# EUROPEAN PATENT APPLICATION

(11) **EP 0 849 772 A1**
(43) Date of publication of application: **24.06.1998**
(21) Application number: 96870162.3
(22) Date of filing: 20.12.1996
(51) Int. Cl.: H01L 21/00

(54) **Apparatus and method for wet cleaning or etching of flat substrates**

(71) Applicant: INTERUNIVERSITAIR MICRO-ELEKTRONICA CENTRUM VZW, 3001 Heverlee (BE)
(72) Inventor: Meuris, Marc, 3140 Keerbergen (BE); Mertens, Paul, 2820 Bonheiden (BE); Heyns, Marc, 3210 Linden (BE)
(74) Representative: Van Malderen, Michel

(57) **Abstract**

An apparatus (1) for wet cleaning or etching of flat substrates (9) comprising a tank (3) with an inlet opening (5) and outlet opening (7) for substrates. Said tank containing cleaning liquid (11) and being installed in an environment (13). At least one of the openings is a slice in a sidewall of the tank present below the liquid-surface (15) and being marginally larger than the thickness of said substrates.

In the tank (3) there may be a portion (25) above the liquid (11) filled with a gas with a pressure being lower than the pressure within said environment (13).

The method comprises the step of transferring a substrate through the cleaning or etching liquid at a level underneath the liquid surface making use of said apparatus.

## Description

### Field of the invention

The present invention is related to the fabrication of flat substrates such as semiconductor wafers, flat panel displays, solar cells, or for other applications requiring a cleaning or etching step of flat substrates. The present invention also relates to the microelectronics manufacturing technology. More in particular, an apparatus and method are disclosed for wet cleaning or etching of flat substrates which can be used in the electronics industry.

### Background of the invention

In the processing of Semiconductor Wafers, the semiconductor surface preparation prior to various processing steps such as oxidation, deposition or growth processes, has become one of the most critical issues. With the rapid approach of subhalf micron design rules, very small particles with submicron dimensions and low levels of metal impurities (- 10¹⁰ atoms/cm²) can have a detrimental effect on process yields. A commonly used technique to reduce foreign particulate matter contamination level on semiconductor surfaces, is the immersion of wafers in liquids, by preference chemical solutions. The semiconductor wafers are usually placed into a tank or vessel or wet bench, which holds a liquid for cleaning or etching. Said tank or vessel or wet bench is installed in a clean room environment. Often a wet bench contains several vessels or tanks.

Semiconductor wafers or substrates can be immersed into the liquid from the top surface of the tank. Another way to achieve that the substrates are in contact with liquid is to use a door or an entrance at the side wall of the tank and to place a batch of wafers into the vessel. After the door is closed and sealed, liquid is flowing into the tank, again to make contact between the cleaning or etching liquid and the substrates. In both approaches, one can switch from one liquid to the other liquid in the same tank. This method is commonly denominated as a single tank processor. Variations of these two techniques are also used for single wafer cleaning or etching purposes. E.g. a wafer is placed into a small vessel, which can be larger than the wafer. In some cases, the wafers are immersed into the liquid from the top, in other cases, the wafer is loaded into an empty vessel and the liquid is flowing into the vessel.

A particular apparatus used after cleaning or etching of semiconductor wafers is disclosed in EP 0 385 536, the teaching of which is incorporated herein by reference.

A disadvantage of above-explained methods making use of a tank or vessel is the footprint necessary, this means the surface area within a clean room occupied by the tank or vessel, and the throughput of wafers. Above-explained systems making use of a tank or vessel are big and occupy a large area within a clean room. It is to be understood that clean room area is very expensive due to the costs of maintaining an ultra-clean atmosphere.

Furthermore, when, e.g. a single tank processor is used, switching from one liquid to the other liquid takes time and the system can have a lower throughput compared to a classical wet bench approach.

Another disadvantage of prior art cleaning or etching tools is that a non-uniformity in the cleaning or etching process remains. This is to be understood as follows: when a wafer is dipped in a tank, the bottom part of the wafer is always remaining some longer in the cleaning or etching liquid than the upper part of the wafer. Therefore, the contact-time of several parts of the wafer is not identical.

A further disadvantage of prior art cleaning or etching tools is that a drying step is required after a cleaning or etching step. This drying and/or rinsing step takes extra time and therefore increases the processing time of wafers.

### Summary of the invention

It is an aim of the invention to provide an apparatus for wet cleaning or etching of flat substrates, in particular semiconductor wafers, comprising a tank with an opening for said substrates, said tank containing cleaning or etching liquid and being installed in an environment, for instance a clean-room, whereby the above mentioned disadvantages will have less impact. It is an aim of the present invention to provide an apparatus for wet cleaning or etching of flat substrates, said apparatus yielding a more uniform contact time for several parts of the wafers being processed, and yielding a higher throughput of wafers.

To this end, the apparatus according to the invention is characterised in that, the opening is present below the liquid-surface and the apparatus comprises means to prevent the liquid from flowing through the opening out of the tank into the environment.

An embodiment of the apparatus according to the invention is characterized in that, said means are realized by the dimensions of the opening, which opening being such narrow that the liquid is prevented from flowing through it due to the surface tension and/or the capillary effect of said liquid.

A first embodiment of the apparatus to achieve this is characterized in that the opening is marginally larger than the thickness of said substrates and being, with respect to the thickness of the wall of the tank, a lengthened passage.

Another embodiment of the apparatus to achieve this, is characterized in that, the opening is marginally larger than the thickness of said substrates and being a towards the environment converging passage.

A further embodiment of the apparatus according to the invention, is characterized in that, said means comprise a portion in the tank, which portion being above the liquid and being filled with a gas or a gas mixture with a pressure being lower than the pressure within said environment.

An advantageous embodiment of the apparatus to achieve this, is characterized in that said means comprises a pump connected with the room in the tank for sucking the gas and thereby reducing the gas-pressure in the tank and subsequently reducing the liquid-pressure near the opening.

Another embodiment of the apparatus according to the invention is characterized in that said means comprise a room adjacent to said tank, said room having an opening for said substrates and said room being filled with a gas or a gas mixture with a pressure being higher than the pressure within said environment, the pressure above said liquid in the tank being equal to or lower than the pressure of said environment. Wafers are transferred from said environment through said room into said tank.

Yet in another embodiment of the apparatus according to the invention, said tank can be adjacent to a process chamber wherein, for instance, a gas phase etching process of semiconductor wafers can occur. In this embodiment, wafers are transferred from within said environment through said tank into said process chamber. In this way, the process chamber can be isolated from the environment thereby avoiding the introduction of moisture, oxygen or other rest gases in the chamber. Also, the introduction of wafers into the process chamber through said tank can occur with a relatively simple automation setup. By preference, one tank is located adjacent to the process chamber at the inlet opening of said process chamber and another tank is located adjacent to the process chamber at the outlet opening of said process chamber.

Still another embodiment of the apparatus according to the invention is, characterized in that, said means comprise partitions inside the tank to increase the capillary force, thereby reducing the liquid-pressure near the opening.

Yet a further embodiment of the apparatus according to the invention is characterized in that said means comprise means outside the tank for directing a gas flow towards the opening.

In an advantageous embodiment of the apparatus the gas flow comprises N₂. In another embodiment the gas flow comprises a vapour which is not condensing on said substrate at said opening, said vapour being chosen from a group of substances which are miscible with said liquid and which will form with said liquid a mixture having a surface tension lower than that of said liquid alone. Preferably the vapour is an IPA vapour.

In an embodiment said inlet opening is a slice in the sidewall of said tank and said outlet opening is in another wall of said tank, said substrates being passed essentially horizontally through said apparatus. In another embodiment said inlet opening is a slice in the bottom of said tank and said outlet opening is in the top of said tank, said substrates being passed essentially vertically through said apparatus.

Yet another embodiment of the apparatus according to the invention is characterized in that the tank further comprises an inlet and an outlet for said liquid, said outlet being near said opening and said means comprises a pump connected to the outlet for sucking the liquid and thereby reducing the liquid-pressure near the opening.

The invention furthermore pertains to a method of wet cleaning or etching of flat substrates in particular semiconductor wafers, comprising the steps of putting a substrate via an opening in and out of a tank filled with a cleaning or etching liquid. The method in accordance with the invention is characterized in that the substrate is put into and/or taken out of the cleaning or etching liquid at a level underneath the liquid-surface via an opening in the tank present below the liquid-level in the tank and thereby preventing the liquid from flowing through the opening out of the tank.

An embodiment of the method according to the invention is characterized in that, gas present above the liquid in the tank is sucked out of the tank to reduce the pressure inside the tank.

A further embodiment of the method according to the invention is characterized in that the liquid is sucked out of the tank near said opening to reduce the liquid-pressure near the opening.

Another embodiment of the method according to the invention is characterized in that a gas flow is directed towards said opening from outside the tank to dry the substrate and preventing the liquid from flowing out of the tank.

In the new apparatus and method for wet cleaning or etching of flat substrates, substrates can be loaded and/or unloaded from the bottom or from the sidewall of the tank into said tank filled with liquid. Said apparatus and said method can be used for single substrates or for a batch of substrates.

Said apparatus and said method offer as an advantage the possibility of placing liquid tanks no longer side by side but on top of each other. This approach makes it possible to reduce drastically the footprint of a tank and keeping a high throughput. Also a cleaning tank can be placed directly besides of a next apparatus for further processing. The footprint of said apparatus is also much smaller than the footprint of a classical wet bench. At the same time the apparatus and method disclosed in the present application allow for keeping a high throughput. Said apparatus and said method offer as another advantage the possibility of achieving a uniform cleaning or etching of said wafers being transferred through the cleaning or etching liquid in said tank. As wafers can be transferred at a uniform speed throughout said tank, each part of said wafers is exposed for the same time period to said cleaning or etching liquid. Another advantage of said apparatus and said method is that by the use of dilute chemical mixtures as a cleaning or etching liquid in said tank, a rinsing and/or a drying step after said cleaning or etching step in said tank can be avoided. In this way, a fast processing time of wafers and a high throughput can be achieved. It is disclosed in the art that if a cleaning solution is dilute enough, being diluted preferably with DI-water, wafers may be dried immediately without ultra pure water rinsing after cleaning or etching. As a result, no detrimental residues are left behind on the wafer surface. This works well for instance with dilute HCl being diluted with DI-water: in the range of pH 2 - 4.

Another possibility is to have a very dilute SC1 with a volume mixing ratio of NH₄OH/H₂O₂/H₂O in a range of about 1/1/1000.

Another possible solution that can be used to achieve this purpose is to use ozonated water.

A detailed description of the use of such dilute chemicals for wafer cleaning/rinsing purposes is given in the co-pending patent application "Drying of Wafers Directly From Chemical Baths with No Ultra-Pure Water Rinse" being co-owned by IMEC and Texas Instruments and being known under the reference numbers IMEC 94/13 and TI/19957.

It is to be understood that the apparatus and method disclosed in this patent application can be used for cleaning or etching of any kind of flat substrates. Thus, flat panel display substrates or solar cell substrates or glass substrates or metal plates or printed circuit boards can be cleaned or etched using a specific embodiment of the apparatus according to this invention.

### Brief description of the drawings

The invention will now be further elucidated on the basis of the example embodiments of the apparatus and method according to the invention, as depicted in the drawings. To this end:
Figure 1 provides a vertically cross-section view of a first embodiment of the apparatus according to the invention;
Figure 2 shows a horizontal cross-section of the apparatus;
Figure 3 shows a vertical cross-section of a detail of the apparatus near an opening;
Figure 4 shows a vertical cross-section of a detail of another embodiment of the apparatus near an opening;
Figure 5 provides a vertical cross-section view of a second embodiment of the apparatus according to the invention;
Figure 6 shows a horizontal cross-section of the apparatus;
Figure 7 shows the situation using another gas;
Figure 8 provides a vertically cross-section view of a third embodiment of the apparatus according to the invention;
Figure 9 provides a vertically cross-section view of a fourth embodiment of the apparatus according to the invention; and
Figure 10 shows a different mounting of the first embodiment of the apparatus.

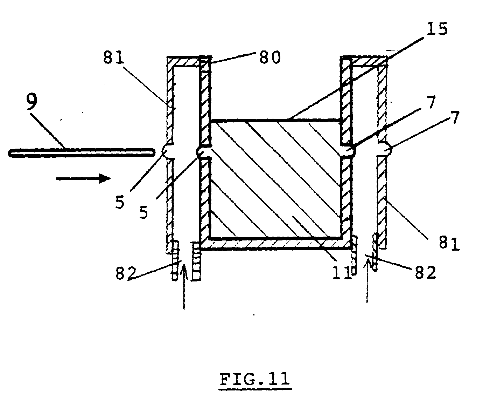

Figure 11 shows a specific embodiment of the apparatus of the present invention with a room at overpressure adjacent to said apparatus.

### Detailed description of preferred embodiments

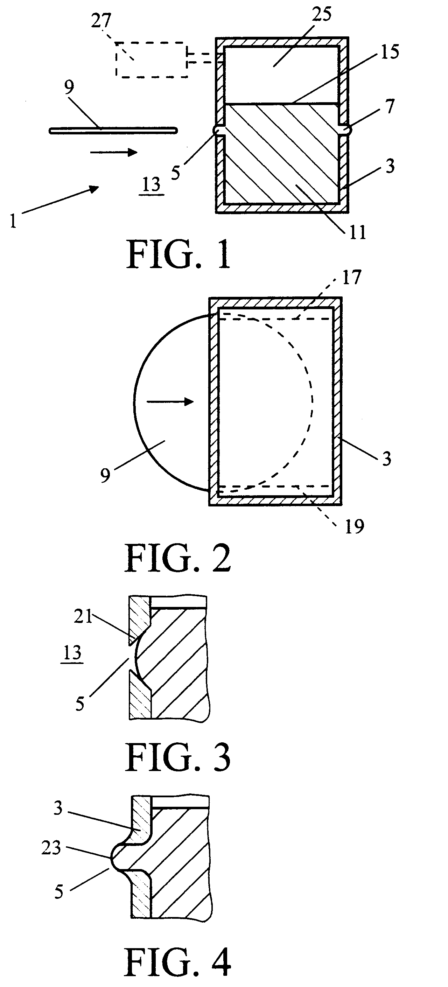

Figure 1 shows a first embodiment of the apparatus according to the invention for wet cleaning or etching of flat substrates, in particular semiconductor wafers. The apparatus 1 comprises a tank 3 with an inlet and an outlet opening 5, 7 for a substrate 9. The tank 3 containing cleaning or etching liquid 11 and being installed in an environment 13, in particular a clean-room. The openings are present below the liquid-surface 15. The openings 5, 7 are such narrow that the liquid 11 is prevented from flowing through it due to the surface tension and/or the capillary effect of said liquid. Figure 2 shows a horizontal cross-section of the apparatus with the substrate 9 partly inserted in the tank 3 and sliding through the apparatus. At both sides the tank 3 contains guiding slits 17, 19 for the substrate transport. When the substrate is too fast taken through the apparatus the water is teared out together with the substrate.

In figures 3 and 4 improved shapes of the openings are shown for maximum prevention of leakage. In the embodiment of figure 3 the opening 5 has a tilted angle 21 and converges towards the environment 13. The opening is marginally larger than the thickness of the substrate. In the embodiment of figure 4 the opening 5 is lengthened with respect to the thickness of the wall of the tank 3.

The form of the meniscus 23 will also depend on the hydrophobicity of the tank wall material. It is possible that the tank wall material has to be treated in such a way that the contact angle versus the liquid, i.e. the surface tension of the material, has to stay stable during the operation.

Advantageously, the tank wall is made of a material that increases the capillary effect of said liquid. Such material can be a plastic.

The tank 3 comprises a portion 25 above the liquid 11 as can be seen in figure 1. This portion 25 is filled with a gas or a gas mixture with a pressure being lower than the pressure within the environment 13. To maintain this reduced pressure a pump 27 may be connected with the portion 25 for sucking the gas and thereby reducing the gas-pressure in the tank and subsequently reducing the liquid-pressure near the openings. This further prevents the liquid from flowing through the openings 5, 7 out of the tank 3. It is advantageous to regulate the pressure as such that no air bubbles are sucked through the openings. The pressure in the portion 25 can be 2 to 3 millibar below the pressure of the environment 13.

The preferred pressure in the portion is depending on the height above the openings 5, 7. The pressure advantageously is regulated such that the liquid in the tank is impeded from flowing out of the tank.

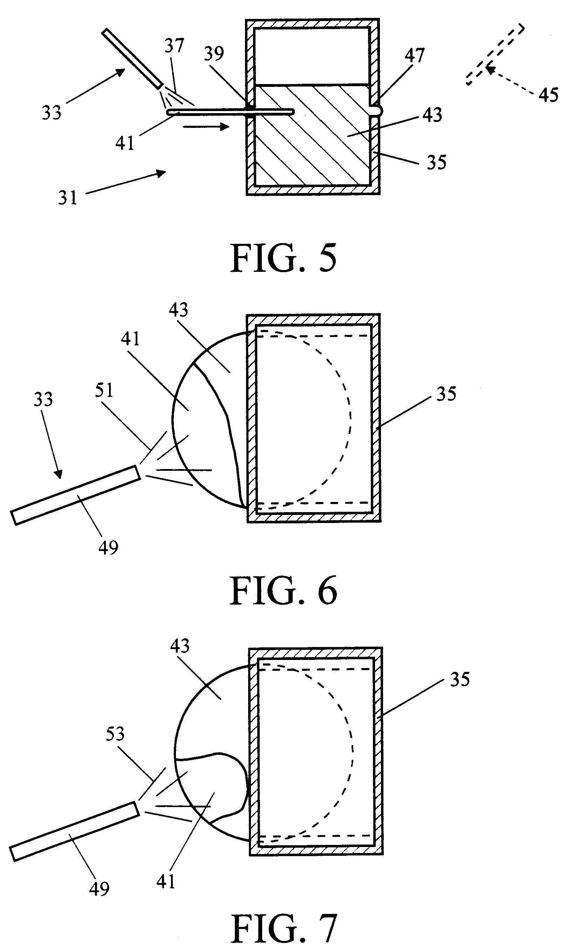

Figure 5 shows a second embodiment of the apparatus according to the invention. In this embodiment the apparatus 31 contains means 33 outside the tank 35 for directing a gas flow 37 towards the opening 39 to dry the substrate 41 and preventing the liquid 43 from flowing out of the tank 35. It is also possible to have further means 45 near the outlet opening 47. In the situation shown in figure 6 an IPA vapour is used. The means can comprise a tube 49 blowing a vapour comprising IPA possibly mixed with another gas. The inlet and/or outlet atmosphere of the tank can be saturated with said vapour. Using the vapour flow 51 over the opening slit of the tank, the substrate 41 can be taken out dry. The marangoni effect is used to change the surface tension at the opening.

In the situation shown in figure 7, N₂ is used instead of the IPA vapour. When only using the N₂ blow 53, only at the blow itself one can observe a drying effect. So, one will have the choice to dry the substrate or with the force of a N₂ blow, or with the marangoni effect, or with a combination of both effects.

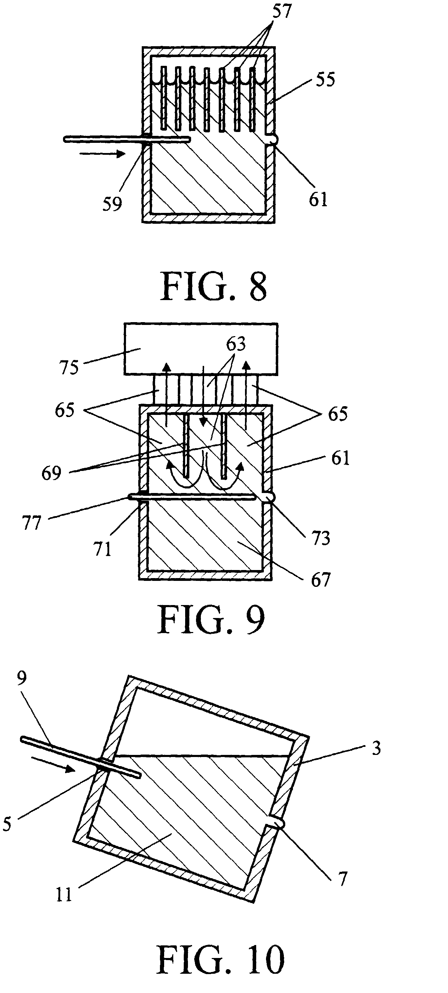

Another way to improve the wet bench is to make use of the capillary force to reduce the pressure at the inlet and outlet openings. This can be done by making use of vertical partitions which create a capillary force on the liquid by which the liquid is kept in the tank. In figure 8 this is shown in a third embodiment of the apparatus according to the invention. Inside the tank 55 there are partitions 57 to increase the capillary force and thereby reducing the liquid-pressure near the openings 59, 61.

A modification to this is the use of a tank of capillary dimension of only a few millimetres width (not shown in the drawings). The substrate is processed in a tank and a line of only a few millimetres width of liquid will touch the substrate. Another modification to this is the use of a tank with a height of only a few millimetres so that the liquid stays in by capillary force.

Another possibility is to make use of a pump to create a small differential pressure at the outlet and inlet openings towards the environment. This is shown in figure 9. The tank 61 comprises an inlet 63 and an outlet 65 for the cleaning or etching liquid 67. Vertical plates 69 are inserted to guide the flow as shown by the picture. The outlet is near the openings 71, 73. A pump 75 is connected to the outlet for sucking the liquid and thereby reducing the liquid-pressure near the opening. When the plates 69 are sufficiently near the substrate 77 the velocity of the liquid will be sufficiently high close to the substrate surface to improve the supply of fresh solution.

In the above embodiments the inlet opening is a slice in the sidewall of the tank, the outlet opening is in another wall of the tank and the substrates being passed essentially horizontally through the apparatus. It is possible that only the outlet opening is under the liquid level, the outlet opening thus being in contact with the liquid and the inlet opening not being in contact with the liquid. It is also possible (not shown in the drawings) to make the inlet opening as a slice in the bottom of the tank and the outlet opening in the top of the tank, whereby the substrates being passed essentially vertically through the apparatus.

Another embodiment of the apparatus according to the invention is characterized in that said means comprise a room 81 adjacent to said tank 80, said room 81 having an opening for said substrates and said room 81 being filled with a gas or a gas mixture with a pressure being higher than the pressure within said environment, the pressure above said liquid in the tank 80 being equal to or lower than the pressure of said environment. The opening of said room 81 advantageously is at the same height as the opening of said tank 80.

A connection 82 is provided on said room 81 to allow making an overpressure in the room 81, preferentially by means of a gas flow being held at a pressure higher than the pressure of said environment.

Although the invention has been elucidated on the basis of the accompanying drawings in the discussion to this point, it should be noted that the invention is in no way restricted to just those embodiments depicted in the drawings. The invention also encompasses all the derivative embodiments which differ from the depicted embodiments within the scope defined in the claims. As an example, it is also possible to improve the inlet of the wet bench and facilitate the inlet of the substrate in the tank by tilting the device. This is shown in figure 10. This gives the potential that at the inlet no marangoni dry or other force will be necessary to place the substrate in the device. Only at the outlet a drying technique has to be present now. Also note that the tank has the potential to contain a scrubber at the inside for both sides substrate cleaning or etching.

## Claims

1. Apparatus for wet cleaning or etching of flat substrates comprising a tank with an opening for said substrates, said tank containing cleaning or etching liquid and being installed in an environment characterized in that the opening is present below the liquid-surface and the apparatus comprises first means to prevent the liquid from flowing through the opening out of the tank into the environment.

2. An apparatus as claimed in claim 1, characterized in that said first means are realized by the dimensions of the opening, which opening being such narrow that the liquid is prevented from flowing through it due to the surface tension and/or the capillary effect of said liquid.

3. An apparatus as claimed in claim 2, characterized in that the opening is marginally larger than the thickness of said substrates.

4. An apparatus as claimed in claim 2, characterized in that the opening is marginally larger than the thickness of said substrates being, with respect to the thickness of the wall of the tank, a lengthened passage.

5. An apparatus as claimed in claim 2, characterized in that the opening is marginally larger than the thickness of said substrates being towards the environment a converging passage.

6. An apparatus as claimed in claim 1, characterized in that said first means comprise a room adjacent to said tank, said room having an opening for said substrates and said room being filled with a gas or gas mixture with a pressure being higher than the pressure with said environment.

7. An apparatus as claimed in claims 1 to 6, characterized in that said first means comprise a second portion in the tank, said second portion being above the liquid and being filled with a gas or a gas mixture with a pressure being lower than the pressure within said environment.

8. An apparatus as claimed in claim 7, characterized in that said means comprise a pump connected with the second portion in the tank for sucking the gas, thereby reducing the gas-pressure in said second portion and subsequently reducing the liquid-pressure near the opening.

9. An apparatus as claimed in any one of the preceding claims, characterized in that said first means comprise partitions inside the tank to increase the capillary force, thereby reducing the liquid-pressure near the opening.

10. An apparatus as claimed in any one of the preceding claims, characterized in that said liquid is a dilute chemical.

11. An apparatus as claimed in any one of the preceding claims, characterized in that the said first means comprise means outside the tank for directing a gas flow towards the opening.

12. An apparatus as claimed in claim 11, characterized in that said gas flow comprises N₂ as a constituent of the gas flow mixture.

13. An apparatus as claimed in claim 11, characterized in that the gas comprises a vapour which is not condensing on said substrate at said opening, said vapour being chosen from a group of substances which are miscible with said liquid and which will form with said liquid a mixture having a surface tension lower than that of said liquid alone.

14. An apparatus as claimed in claim 10, characterized in that the vapour comprises IPA.

15. An apparatus as claimed in any one of the preceding claims, characterized in that said opening comprises an inlet opening and an outlet opening, said inlet opening being a slice in the sidewall of said tank and said outlet opening being in another wall of said tank, said substrates being passed essentially horizontally through said apparatus.

16. An apparatus as claimed in any one of the preceding claims, characterized in that said inlet opening is a slice in the bottom of said tank and said outlet opening is in the top of said tank, said substrates being passed essentially vertically through said apparatus.

17. An apparatus as claimed in any one the preceding claims, characterized in that said flat substrates are semiconductor wafers and said environment is a clean room.

18. Method of wet cleaning or etching of flat substrates comprising the steps of putting a substrate in and out of a tank filled with a cleaning or etching liquid, characterized in that the substrate is put into and/or taken out of the cleaning or etching liquid at a level underneath the liquid-surface via an opening in the tank present below the liquid-level in the tank while preventing the liquid from flowing through the opening out of the tank.

19. Method as claimed in claim 18, characterized in that a gas present above the liquid in the tank is sucked out of the tank to reduce the pressure inside the tank.

20. Method as claimed in claim 18, characterized in that the liquid is sucked out of the tank to reduce the liquid-pressure near the opening.

21. Method as claimed in claims 18, 19 or 20, characterized in that a gas flow is directed towards said opening from outside the tank to dry the substrate and preventing the liquid from flowing out of the tank.

22. A method of wet cleaning or etching of flat substrates comprising the steps of transferring said wafers through a tank filled with a cleaning or etching liquid characterized in that said substrates are introduced into said tank through an inlet opening and taken out of said tank through an outlet opening underneath the liquid-surface and are transferred at a uniform speed through said liquid thereby exposing essentially each part of said substrate to said liquid for the same time period.
